# EUROPÄISCHE PATENTSCHRIFT

(11) **EP 0 946 965 B1**
(45) Veröffentlichungstag und Bekanntmachung des Hinweises auf die Patenterteilung: **17.05.2006**
(21) Anmeldenummer: 97953900.4
(22) Anmeldetag: 22.12.1997
(51) Int. Cl.: H01J 37/34

(54) **VORRICHTUNG UND VERFAHREN ZUR KATHODENZERSTÄUBUNG**
DEVICE AND METHOD FOR CATHODIC SPUTTERING
DISPOSITIF ET PROCEDE DE PULVERISATION CATHODIQUE

(30) Priorität: 21.12.1996 DE 19654000; 21.12.1996 DE 19654007; 21.12.1996 DE 19653999
(43) Veröffentlichungstag der Anmeldung: 06.10.1999
(73) Patentinhaber: Singulus Technologies AG, 63755 Alzenau (DE)
(72) Erfinder: SICHMANN, Eggo, D-63571 Gelnhausen (DE); MÜCKE, Michael, D-61184 Karben (DE); BECKER, Wolfgang, D-64850 Schaatheim (DE); TRUCKENMÜLLER, Klaus, D-63924 Kleinheubach (DE)
(74) Vertreter: Vossius & Partner
(86) Internationale Anmeldenummer: PCT/EP1997/007225
(87) Internationale Veröffentlichungsnummer: WO 1998/028777

(56) Entgegenhaltungen:
- DE-A- 4 329 155
- DE-C- 4 100 291
- DE-C- 19 654 000
- US-A- 3 956 093
- US-A- 5 182 001

## Beschreibung

Die Erfindung bezieht sich auf eine Vorrichtung und ein Verfahren zur Magnetron-Kathodenzerstäubung für die Herstellung von Schichten auf einem Substrat mittels einer in eine Vakuumkammer einbringbaren Zerstäubungskathode, die vorzugsweise mit Bezug auf die Mittelachse der Zerstäubungskathode Polschuhe, ein Target und mindestens einen konzentrisch bzw. ringförmig angeordneten Magneten aufweist.

Es ist bereits eine Vorrichtung zur Kathodenzerstäubung für die statische Beschichtung scheibenförmiger Substrate mittels eines Plasmas in einer Vakuumkammer mit mindestens einer Öffnung bekannt (DE 43 15 023 A1), welche durch Auflegen einer Zerstäubungskathode von außen verschließbar ist. Zwischen der Kathode und der Kammerwand sind ein elastischer Vakuumdichtring sowie eine ringförmige Anode vorgesehen, die die Öffnungen radial von außen umgeben, wobei die Anode auf ihrer zur Kathode hin zeigenden Seite eine ebene Kontaktfläche aufweist. Die bekannte Zerstäubungskathode besteht aus einem scheibenförmigen, ferromagnetischen Joch und einer Kühlplatte. Zwischen beiden ist ein scheibenförmiger Isolator eingelegt. Vor der Kühlplatte befindet sich das zu zerstäubende Target, während auf der Rückseite der Kühlplatte in einer Nut ein ringförmig angeordneter Magnet eingelegt ist. Durch den ringförmig angeordneten Magneten wird ein Gegenmagnetfeld erzeugt, welches den Verlauf der Magnetfeldlinien beeinflußt. Hierdurch erhält der Verlauf der Magnetfeldlinien einen annähernd parallelen bzw. linsenförmigen oder konvexen Verlauf.

Aus der US-5 262 030 ist eine Magnetron-Zerstäubungskathode mit einem variablen Magnetfeld während der Beschichtung bekannt. Durch das Magnetfeld wird der Bereich des Target bestimmt, von dem Material abgetragen wird. Dabei ist eine Anordnung von mehreren Magneten hinter der Zerstäubungskathode vorgesehen, die selektiv ein- bzw. ausgeschaltet werden, um ein Magnetfeld parallel zur Targetoberfläche zu erzeugen oder nicht. Dabei kommt es durch Überlagerung zu einer Bewegung des Magnetfelds radial nach außen oder über bestimmte Bereiche des Targets. Da jeweils vorher festgelegte Magnetfelder zu- oder abgeschaltet werden, wird das Magnetfeld im Bereich der Targetoberfläche diskontinuierlich verändert.

Die US-A-3 956 093 betrifft ein Verfahren und eine Vorrichtung zur Magnetron-Kathodenzerstäubung mit einer in einer Vakuumkammer angeordneten Zerstäubungskathode, Polschuhen, einem Target und einem Magnetfeld im Bereich der Targetoberfläche, das durch Überlagerung eines statischen mit einem veränderbaren Magnetfeld erzeugt wird. Das veränderbare Magnetfeld wird durch Spulen erzeugt, die in einer Ebene mit dem Target angeordnet sind.

Die US-A-5 182 001 offenbart ein Verfahren zum Beschichten von Substraten durch Magnetron-Kathodenzerstäubung. Das Verfahren sieht ein veränderbares Magnetfeld im Bereich der Targetoberfläche durch Überlagerung eines statischen Magnetfeldes mit einem veränderlichen Magnetfeld, erzeugt durch eine Spule, vor. Die das statische Magnetfeld erzeugenden Permanentmagneten weisen Pole auf, die einerseits außerhalb der äußeren Kante des Targets und andererseits innerhalb der inneren Kante des Targets vorgesehen sind. Im äußeren Bereich des Permanentmagneten, an der äußeren Kante des Targets ist eine Magnetspule zum Erzeugen des veränderlichen Magnetfeldes vorgesehen, die sich in vertikaler Richtung über die Oberfläche des Targets hinaus erstreckt.

Der Erfindung liegt die Aufgabe zugrunde, eine verbesserte Vorrichtung und ein verbessertes Verfahren zur Kathodenzerstäubung zur Verfügung zu stellen, wobei die Targetausbeute verbessert und gleichzeitig eine hohe Gleichmäßigkeit in der Schichtdicke erzielt wird.

Die Aufgabe wird durch die Merkmale der Patentansprüche gelöst.

Zur Anpassung an die Form des Substrats können die Kathode, das Target, das Joch und die Magnetanordnung z.B. eine ringförmige, rechteckige, elliptische, oder eine andere Form annehmen, wenn das Substrat z.B. kreisförmig, rechteckig, elliptisch oder anderweitig geformt ist.

Vorzugsweise ist neben einem an die Form des Substrats angepaßt angeordneten Magneten mindestens ein weiteres ein kontinuierlich veränderbares Magnetfeld erzeugendes Teil im Bereich des Targets vorgesehen. Durch die vorteilhafte Anordnung des Magneten neben dem ein veränderbares Magnetfeld erzeugenden Teil erhält man auch bei unterschiedlich großem Substrat eine gleichmäßige Schichtdicke, wobei die Abweichungen der Schichtdicke zwischen ± 2 % bis 3 % liegen können. Der Sputtergraben bildet sich in Abhängigkeit des ein-gestelltenMagnetfelds aus. Bei dieser Anordnung des Magneten in Verbindung mit dem ein veränderbares Magnetfeld erzeugenden Teil wird das Hauptmagnetfeld so ausgebildet, daß über die gesamte Prozeßdauer eine gezielte Beeinflussung des Erosionsgrabens sichergestellt werden kann.

Durch die vorteilhafte Anordnung des z.B. ringförmig angeordneten Magneten in Verbindung mit dem ein veränderbares Magnetfeld erzeugenden Teil bzw. mindestens einer Spule wird eine kontinuierliche Veränderung des Magnetfelds, insbesondere im Bereich der Targetoberfläche, erreicht. Dabei verlaufen die magnetischen Flußlinien von der Mitte nach außen bzw. von außen nach innen und nehmen dabei eine Linsenform ein, so daß man einen möglichst breiten Erosionsgraben erzielen kann. Erhält man nach einer längeren Prozeßdauer einen konkaven Erosionsgraben, so ist es vorteilhaft, daß sich mit Bezug auf die Targetoberfläche in etwa parallel verlaufende Magnetfeldlinien einstellen. Eine Schirmplatte verhindert einen Eintritt der Magnetfeldlinien in das Joch. In vorteilhafter Weise können diese Spulen auch zeitabhängig gesteuert werden, so daß man einerseits die Lebensdauer eines Targets und andererseits über eine Zykluszeit das Magnetfeld variieren kann. Es kann z.B. empirisch eine Steuerkurve (f_{(I)} = I₍ₜ₎) ermittelt werden, die gewährleistet, daß erstens das Substrat sehr gleichmäßig beschichtet wird und zweitens das Target optimal ausgebeutet wird. Die so empirisch ermittelte Steuerkurve, z.B. für ein Goldtarget, kann dann immer wieder für den Beschichtungsprozeß eingesetzt werden. Der Steuerprozeß für den Beschichtungsvorgang kann auch mittels eines Programms überwacht werden.

Mit den hier verwendeten Spulen läßt sich auf sehr kostengünstige Weise ein variables Magnetfeld erzeugen.

Erfindungswesentlich ist es, daß durch die Verwendung von Magnetspulen das Magnetfeld im Targetraum gezielt beeinflußt und variiert wird, so daß man das Plasma radial von innen nach außen verschieben kann. Hierdurch erreicht man, daß der Erosionsgraben radial über das Target verschoben bzw. verändert werden kann, womit man die Möglichkeit hat, einmal einen sehr breiten Erosionsgraben, indem man das Magnetfeld kontinuierlich variiert, oder zwei Erosionsgräben nebeneinander zu erzeugen, indem man das Magnetfeld stufenweise hin-und herschaltet.

Ferner ist es vorteilhaft, daß zwischen dem Target oder zwischen Targetrückseite und Jochplatte mindestens eine erste Spule oder z. B. ringförmig angeordnete Spule vorgesehen ist.

Eine zusätzliche Möglichkeit ist gemäß einer Weiterbildung der erfindungsgemäßen Vorrichtung, daß im Bereich der Jochplatte oder im Bereich des Außenumfangs der Jochplatte mindestens ein ringförmig angeordneter Magnet vorgesehen ist.

In weiterer Ausgestaltung der Erfindung ist es vorteilhaft, daß im Bereich des Außenumfangs des Targets die erste Magnetspule und im Bereich des Kühlkopfs die zweite Magnetspule vorgesehen ist.

Gemäß einer bevorzugten Ausführungsform der erfindungsgemäßen Lösung ist schließlich vorgesehen, daß die beiden Magnetspulen etwas oberhalb der oberen Begrenzung oder der Rückseite des Targets vorgesehen sind.

Von besonderer Bedeutung ist für die vorliegende Erfindung, daß die beiden Magnetspulen auf der gleichen Querebene angeordnet sind.

Im Zusammenhang mit der erfindungsgemäßen Ausbildung und Anordnung ist es von Vorteil, daß die beiden Magnetspulen auf der gleichen Querebene zwischen einer ersten oder zweiten Jochplatte und der Rückseite des Targets angeordnet sind.

Vorteilhaft ist es ferner, daß der im Bereich des Außenumfangs des ersten und/oder zweiten Jochs bzw. der Jochplatte vorgesehene, z. B. ringförmig angeordnete Magnet zwischen der unteren bzw. ersten Jochplatte und der oberen bzw. zweiten Jochplatte vorgesehen ist.

Außerdem ist es vorteilhaft, daß die beiden Magnetspulen und der ringförmig angeordnete Magnet konzentrisch zur Mittelachse der Zerstäubungskathode angeordnet sind.

Hierzu ist es vorteilhaft, daß der ringförmig angeordnete Magnet einen Außendurchmesser aufweist, der in etwa gleich, kleiner oder größer als der Außendurchmesser der ersten Spule ist.

Ferner ist es vorteilhaft, daß in einem zwischen Target und mindestens einer Jochplatte vorgesehenen Isolator und/oder dem Target Ringkammern zur Aufnahme der Spule oder ringförmig angeordnete Spulen vorgesehen sind.

Eine zusätzliche Möglichkeit ist gemäß einer Weiterbildung der erfindungsgemäßen Vorrichtung, daß die zwei spulen oder ringförmig angeordneten Spulen unterschiedlich große Durchmesser aufweisen.

In weiterer Ausgestaltung der Erfindung ist es vorteilhaft, daß die zweite ringförmig angeordnete Spule einen kleineren Außendurchmesser aufweist als die erste Spule.

Die erfindungsgemäße Anordnung gewährleistet, daß der ringförmig angeordnete Magnet eine in Richtung des Substrats zeigende N/S-Polung aufweist.

In weiterer Ausgestaltung der Erfindung ist es vorteilhaft, daß ein Abschirmteil zwischen den beiden Spulen vorgesehen ist.

Eine zusätzliche Möglichkeit gemäß einer Weiterbildung der erfindungsgemäßen Antriebsvorrichtung besteht darin, daß das Abschirmteil zwischen einer der Jochplatten und dem Target vorgesehen ist.

Von Vorteil ist es ferner, daß das Abschirmteil zwischen einer der Jochplatten und/oder einem Isolator und dem Target vorgesehen ist.

Eine wesentliche, vorteilhafte Ausführungsform erreicht man dadurch, daß die beiden Jochplatten in Richtung der Mittelachse mit Abstand zueinander angeordnet sind.

Vorteilhaft ist es außerdem, daß der Abstand zwischen den beiden Jochplatten in etwa der Höhe des ringförmig angeordneten Magneten entspricht.

Ferner ist es vorteilhaft, daß die beiden Jochplatten unterschiedlich große Außendurchmesser aufweisen bzw. in Form einer Treppenstufe angeordnet sind.

Eine zusätzliche Möglichkeit ist gemäß einer Weiterbildung der erfindungsgemäßen Vorrichtung, daß die im Außendurchmesser kleinere Jochplatte mit dem Kühlfinger und die im Außendurchmesser größere Jochplatte mit dem Polschuh mittel- oder unmittelbar verbunden ist.

Bevorzugt sind Sensoren vorgesehen, die die Schichtdicke auf dem Substrat, die Form der Targetoberfläche und/oder des Magnetfeldes ermitteln.

Hierzu ist es vorteilhaft, daß der an die Spulen angelegte Strom in Abhängigkeit von der Zeit und/oder von den Sensorsignalen veränderbar ist.

Außerdem ist es vorteilhaft, daß der an die Spulen angelegte Strom bzw. die Stromzufuhr zu den Spulen über eine Steuerkurve bzw. über ein vorab festgelegtes Programm steuerbar ist und die Stromleitungen hierzu über einen Stromteiler mit einem Rechner in Wirkverbindung stehen.

Vorteilhafterweise kann die Zerstäubungsenergie ortsabhängig und zeitabhängig auf dem Target, eingestellt werden und so eine hohe Gleichmäßigkeit der Schicht und der Targetausnutzung erreicht werden. Außerdem kann die Beschichtung während des Prozesses überwacht und geregelt werden.

Weitere Vorteile und Einzelheiten der Erfindung sind in den Patentansprüchen und in der Beschreibung erläutert und in den Figuren dargestellt. Es zeigen:
- Figur 1: eine Schnittdarstellung eines Targets mit mehreren konzentrisch angeordneten Spulen und einem Ring aus Permanentmagneten,
- Figur 2: eine schematische Darstellung eines treppenförmig ausgebildeten Jochs,
- Figur 3: eine schematische Darstellung eines Polschuhs mit den entsprechenden Magnetfeldlinien,
- Figuren 4 bis 6: drei schematische Darstellungen eines treppenförmig ausgebildeten Jochs mit verschiedenen Anordnungen des Abschirmteils,
- Figur 7: eine Anordnung zur gleichmäßigen Beschichtung eines Substrats,
- Figur 8: ein Strom-, Leistunge- und Energiediagramm für einen Zerstäubungsprozeß mit zwei diskreten Zerstäubungspositionen,
- Figur 9a: die Verteilung der Schichtdicke über das Substrat vor einer Regelung,
- Figur 9b: die Verteilung der Schichtdicke auf einem Substrat nach einer Regelung,
- Figur 10a: Zerstäubung des Targets bei stationärem Plasma,
- Figur 10b: Zerstäubung des Targets bei wanderndem Plasma,
- Figur 11: Regelkreis für die Beschichtung,
- Figur 12a: Meßanordnung für ein zylindersymmetrisches Substrat, und
- Figur 12b: Diagramm der Schichtdicke (Transmission) der Meßanordnung gemäß Fig. 12a.

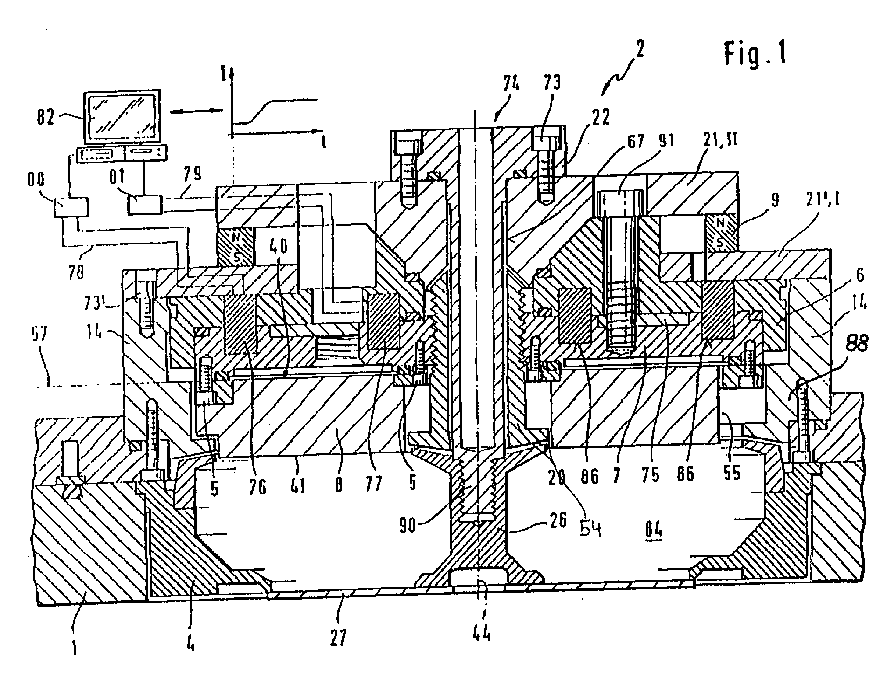

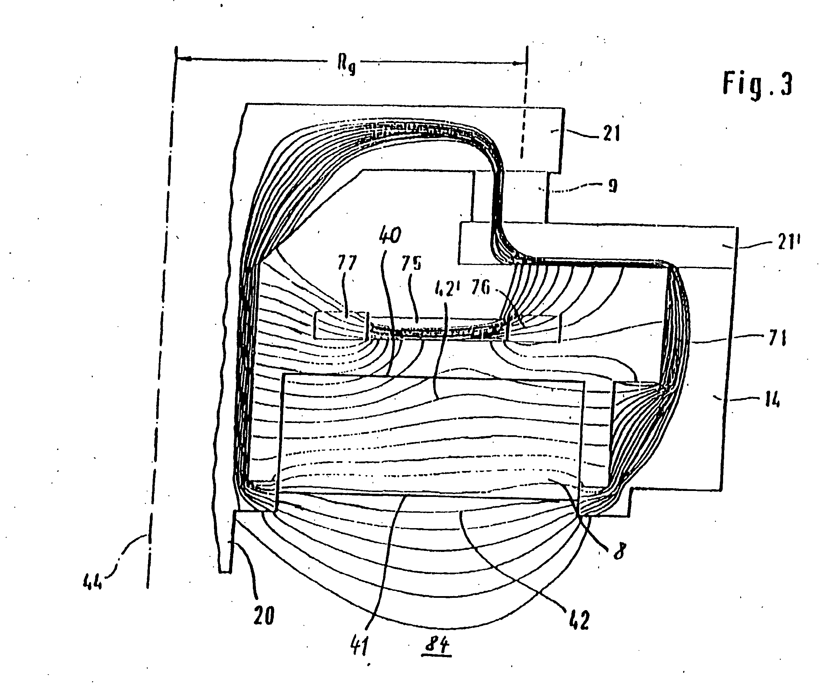

Fig. 1 zeigt eine Vorrichtung zur Kathodenzerstäubung für die Herstellung von Schichten auf einem Substrat, beispielsweise einer Compact Disk (CD) 27. Für den Prozeßablauf kann die mit 2 bezeichnete Zerstäubungskathode in eine Kammerwand 1 der Vorrichtung zur Kathodenzerstäubung eingesetzt werden. Die Kathode besteht aus einem scheibenförmigen, ferromagnetischen, ersten unteren Joch 21' (I) und einem mit Abstand dazu angeordneten, zweiten bzw. oberen Joch 21 (II). Das erste Joch 21' hat einen Durchmesser, der größer ausgebildet ist als der Durchmesser des zweiten Jochs 21.

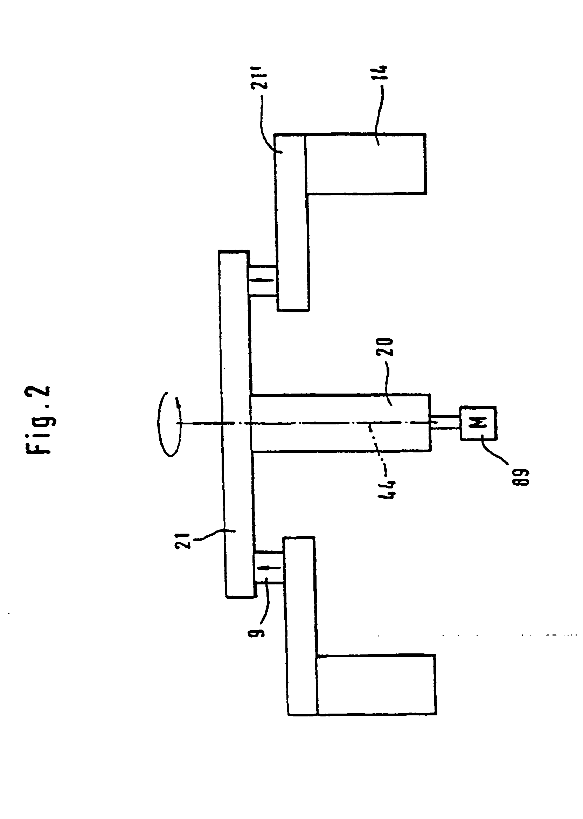

Wie aus den Figuren 1, 2 und 3 hervorgeht, sind die beiden Joche 21, 21' in Form einer Treppenstufe rotationssymmetrisch zu einer Längsmittelachse 44 der Zerstäubungskathode 2 angeordnet und weisen untereinander einen ausreichend großen Abstand auf, so daß in diesen Zwischenraum ein ringförmig angeordneter Magnet 9 ebenfalls rotationssymmetrisch zur Längsmittelachse 44 angeordnet werden kann. Dieser ringförmig angeordnete Magnet 9 weist mit Bezug auf ein Target 8 eine N/S-Polung auf. Die Joche 21, 21', der Magnet 9 und der Polschuh 14 am Joch 21' können um die Längsmittelachse 44 mittels einer Antriebsvorrichtung 89 gedreht werden.

Die im Außendurchmesser kleinere bzw. innere Jochplatte 21 ist mit einem Kühlfinger 74 und die im Außendurchmesser größere Jochplatte 21' mit einem Polschuh 14 mittel- oder unmittelbar verbunden.

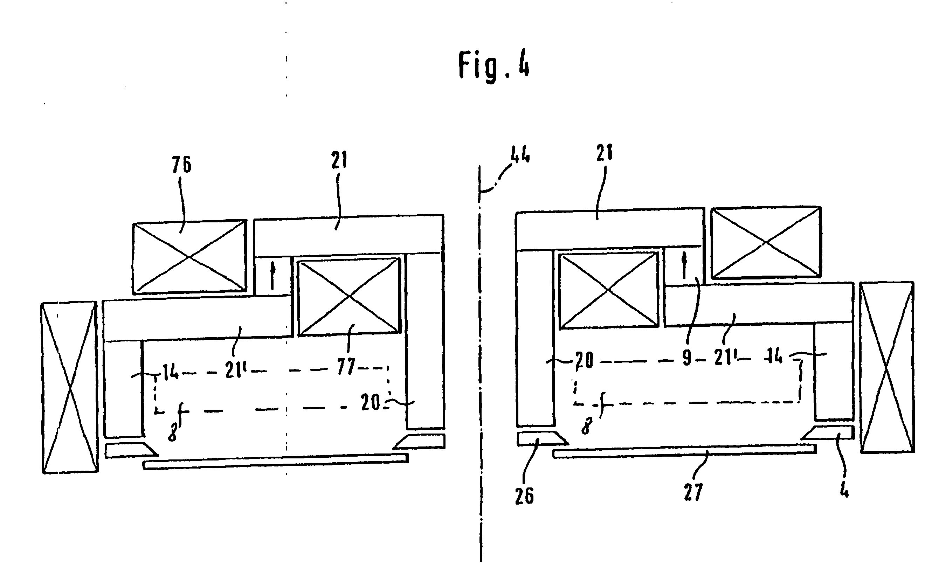

Im Bereich der Jochplatten 21, 21' sind z.B. in Fig. 3 ein ein veränderbares Magnetfeld erzeugendes Teil bzw. eine oder mehrere Magnetspulen 76, 77 vorgesehen.

Die beiden in Fig. 1 dargestellten Magnetspulen 76, 77 liegen auf einer gleichen Querebene unterhalb der unteren, horizontal verlaufenden Ebene der Jochplatte 21'. Im Bereich des Außenumfangs 55 des Targets 8 kann die erste Magnetspule 76 und im Bereich des Innenumfangs 54 des Targets 8 bzw. im Bereich des Kühlfingers bzw. Kühlkopfs 74 die zweite Magnetspule 77 vorgesehen sein. Die beiden Magnetspulen 76, 77 sind etwas oberhalb einer oberen Begrenzung 57 oder der Rückseite 40 des Targets 8 vorgesehen. Es ist dabei vorteilhaft, wenn der im Bereich des Außenumfangs des ersten und/oder zweiten Jochs 21, 21' vorgesehene, ringförmig angeordnete Magnet 9 zwischen der oberen bzw. zweiten Jochplatte 21 und der unteren bzw. ersten Jochplatte 21' vorgesehen ist und die beiden Magnetspulen 76, 77 und der ringförmig angeordnete Magnet 9 konzentrisch zur Mittelachse 44 der Zerstäubungskathode 2 angeordnet sind.

Die Zerstäubungskathode 2 weist ferner eine Kühlplatte 7 auf. Zwischen dem Joch 21' und der Kühlplatte 7 ist ein Isolator 6 eingeklemmt und mittels Schraubenbolzen 91 gesichert.

Vor der Kühlplatte 7 ist das zu zerstäubende Target 8 angeordnet und mittels Schrauben 5 in dieser befestigt. Auf der Rückseite der Kühlplatte 7 befinden sich eine bzw. zwei Ringnuten 86 zur Aufnahme einer inneren und einer äußeren Magnetspule 76, 77, die konzentrisch zur Mittelachse 44 des Targets 8 angeordnet sind.

Das Joch bzw. der Isolator 6 und die Kühlplatte 7 werden durch Schrauben 91 und den Kühlfinger 74 gesichert. Die Schraube 91 bzw. eine Schraube 73 ist in vorteilhafter Weise durch den Isolator 6 gegen das Joch isoliert.

An die Magnetspulen 76, 77 kann über elektrische Leitungen 78, 79 eine Stromversorgung angeschlossen werden, die zur Erzeugung des Magnetfelds dient.

Der Magnet 9 ist an das Joch 21 und/oder 21' und den Polschuh 14 zur Leitung des magnetischen Flusses angekoppelt und bildet somit den kompletten Magnetfeldeinschluß.

Das untere Ende des Polschuhs 14 bildet einen Flansch 88, an den die Außenmaske bzw. eine Anode 4 angeschlossen ist. Die Höhe des Polschuhs 14 und/oder die Höhe der Anode 4 ist veränderbar.

Am unteren Ende der Anode 4 befindet sich das Substrat 27, das gemeinsam mit der Anode 4 und der Targetoberfläche 41 den Targetraum 84 einschließt.

Im Bereich der Mittelachse 44 der Zerstäubungskathode 2 befindet sich eine Bohrung 67, die sich durch die gesamte Vorrichtung erstreckt und zur Aufnahme einer Hohlschraube 20 und des Kühlfingers 74 dient. Der Kühlfinger 74 kann mit einer in der Zeichnung nicht dargestellten Kühlleitung verbunden sein.

An das obere Ende der Hohlschraube 20 schließt sich in axialer Richtung berührungsfrei das zweite Joch 21 mit einer Jochplatte an.

Am oberen Ende des Kühlkopfs bzw. des Kühlfingers 74 ist mittels eines Flansches 22 das zweite Joch 21 (II) befestigt, während, das erste Joch 21' (I) an den Polschuh 14 angeschlossen ist und mittels Schrauben 73, 73' gesichert werden kann.

An die Stirnseite bzw. an das untere Ende eines Gewindeteils 90 des Kühlfingers 74 ist eine Mittelmaske bzw. eine Mittelanode 26 lösbar angeschlossen. Die Mittelanode 26 reicht bis in die zentrische Vertiefung des Targets 8, welche an der Vorderseite des Targets vorgesehen ist, und bildet mit ihrem unteren Ende mit der Außenanode 4 bzw. Außenmaske eine ringförmige Fläche für die Maskierung des Substrats 27.

Der Abstand zwischen dem ringförmig angeordneten Magneten 9 und der Mittelachse 44 ist je nach Ausführungsform veränderbar. Auf jeden Fall liegt der ringförmig angeordnete Magnet 9 zwischen der Mittelachse 44 und dem Polschuh 14. Wie aus Fig. 1 hervorgeht, kann ein Abschirmteil 75 zwischen den beiden Spulen 75, 77 vorgesehen sein. Ferner ist es möglich, daß das Abschirmteil 75 zwischen einer der Jochplatten 21, 21' und dem Target 8 vorgesehen ist. Das Abschirmteil 75 ist ein Eisenkern für die Spulen 76, 77 und verstärkt deren Magnetfeld, und gleichzeitig schirmt es den Targetraum 84 gegenüber Kurzschlußfeldlinien des Magneten 9 ab, so daß man mit relativ geringen Strömen mittels der Spulen eine Feldveränderung vornehmen kann. Hierzu kann das Abschirmteil 75 zwischen einer der Jochplatten 21, 21' und/oder dem Isolator 6 sowie dem Target 8 vorgesehen sein. Der Magnet 9 dient zur Erzeugung des Magnetron-Magnetfelds. Gemäß Fig. 3 haben die Feldlinien 71 der Kathode bzw. des Sputter-Magnetrons als Feldlinien 42 einen konvexen Verlauf über der Targetoberfläche 41 und als Feldlinien 42' einen abgeflachten oder in etwa parallelen Verlauf zur Targetrückseite 40.

Dies wird in vorteilhafter Weise auch durch das Abschirmteil 75 bewirkt. Eine derartige Anordnung eignet sich insbesondere bei einem nicht-ferromagnetischen Metalltarget, z.B. einem Gold- bzw. Aluminium-Target.

Etwas unterhalb des ringförmig angeordneten Magneten 9 befinden sich die beiden Magnetspulen 76, 77. Der ringförmig angeordnete Magnet 9 kann aus zahlreichen einzelnen, ringförmig angeordneten Magneten gebildet sein. Wie aus Fig. 1 hervorgeht, weist der äußere, ringförmig angeordnete Magnet einen größeren Abstand zur Targetrückseite 40 auf als die beiden Magnetspulen 76 und 77.

Je nach Ausführung des Targets 8, das beispielsweise als Aluminium-Target oder als Goldtarget ausgebildet sein kann, kann neben dem ersten ringförmig angeordneten Magneten 9 mindestens ein weiterer in der Zeichnung nicht dargestellter, ringförmig angeordneter Magnet in der Nähe des Magneten 9 vorgesehen sein, um die absolute Feldstärke zu erhöhen.

Die in Fig. 3 dargestellten Magnetspulen 76, 77 dienen zur Variation des Hauptmagnetfelds und können beliebig gepolt sein.

Der an die Spulen 76, 77 angelegte Strom I ist in Abhängigkeit von der Zeit veränderbar. Der an die Spulen 76, 77 angelegte Strom I bzw. die Stromzufuhr zu den Spulen ist über eine Steuerkurve bzw. über ein vorab festgelegtes Programm in einem Rechner 82 steuerbar, und die Stromleitungen 78, 79 stehen hierzu über einen Stromteiler 80 mit einem Rechner 82 in Wirkverbindung. Hierdurch ist eine gezielte Beeinflussung der Targetoberfläche 41 über den gesamten Sputterprozeß möglich, und gleichzeitig wird sichergestellt, daß auf dem Substrat 27 eine sehr gleichmäßige Schichtdicke erzielt wird, wobei die Schichtdickenabweichung zwischen ± 2 % bis 3 % liegen kann. Die erforderliche Steuerkurve läßt sich empirisch ermitteln. Somit kann jeweils für ein entsprechendes Target, z.B. ein Gold- oder Al-Target, eine für die Stromversorgung optimale Steuerkurve ermittelt werden. Weiterhin kann die Schichtdicke auf dem Substrat, die Form der Targetoberfläche und/oder der Magnetfelder durch Sensoren überwacht werden und die Stromzufuhr zu den Spulen 76, 77 entsprechend gesteuert werden.

Besonders vorteilhaft ist es auch, daß das Joch nicht einteilig ausgebildet ist, sondern geteilt wurde und aus zwei einzelnen Teilen, also einer oberen und einer unteren Jochplatte 21, 21', besteht, die aus zwei rotationssymmetrischen Scheiben bestehen und mit Abstand zueinander angeordnet sein können, so daß mindestens ein Magnet 9 zwischen diesen vorgesehen werden kann.

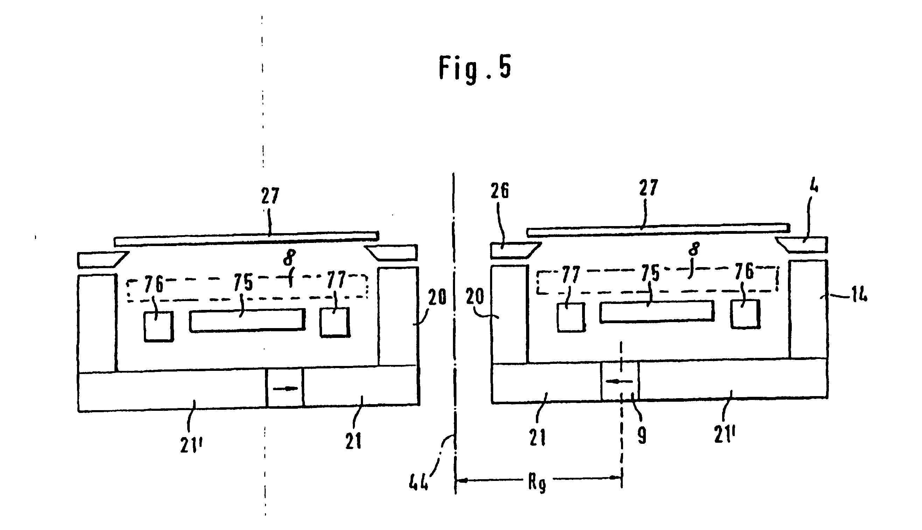

In den Figuren 4 und 5 sind weitere Ausführüngsbeispiele der Vorrichtung zur Kathodenzerstäubung für die Herstellung von Schichten auf einem Substrat 27 gezeigt, bei denen die Spulen 76, 77 bzw die Jochplatten 21, 21' und der Polschuh 14 auch anders als in Figur 1 ausgebildet bzw. angeordnet sein können.

Gemäß Fig. 4 sind die Jochplatten 21, 21' ebenfalls stufenartig ausgebildet, wobei die obere Jochplatte gemäß Fig. 4 mit ihrem inneren Rand an die Hohlschraube 20 und der außenliegende Rand über den ringförmig angeordneten Magneten 9 an den innenliegenden Rand der unteren, stufenartig versetzten, ersten Jochplatte 21' angeschlossen ist. Der äußere Rand der ersten Jochplatte 21' ist an den Polschuh 14 angeschlossen. Die erste Spule 76, die im Durchmesser größer ist als die zweite Spule 77, befindet sich oberhalb der unteren Jochplatte 21' zwischen dem außenliegenden Rand der oberen Jochplatte 21 und dem außenliegenden Rand der unteren Jochplatte 21', während die zweite im Durchmesser kleinere Spule 77 sich unterhalb der oberen Jochplatte 21 zwischen dem innenliegenden Rand der unteren Jochplatte 21' und der Hohlschraube 20 befindet. Die übrige Anordnung dieser Vorrichtung entspricht der Anordnung der Vorrichtung gemäß, Fig. 1.

In Fig. 4 sind die Spulen 76, 77 weiter entfernt vom Target 8 als die Spulen der Beispiele gemäß Figuren 1, 5 und 6. Die spulen gemäß Fig. 4 müssen daher größer ausgebildet sein und mit mehr Strom beschickt werden als die. Spulen 76, 77 der Beispiele gemäß Figuren 1, 5 und 6. Man kann gemäß Fig. 4 das Plasma ebenso hin- und herschieben, wie bei den anderen Ausführungsbeispielen, wobei der Energieaufwand gemäß Fig. 4 etwas höher ist.

Im Ausführungsbeispiel gemäß Fig. 5 sind die Jochplatten 21, 21' ebenfalls geteilt, und diese sind ebenfalls als ringförmige Jochplatten 21, 21' mit unterschiedlich großem Durchmesser ausgebildet, wobei beide Jochplatten auf einer mit Bezug auf die Standfläche der Vorrichtung horizontalen Ebene angeordnet sind, die die Mittelachse 44 in einem rechten Winkel schneidet. Zwischen den beiden Jochplatten 21, 21' liegt der ringförmige Magnet 9. Die beiden ringförmig angeordneten Spulen 76, 77 umgeben den Abschirmteil 75 und befinden sich gemäß Fig. 5 im Targetraum 84. In dem Ausführungsbeispiel gemäß Fig. 5 ist das Joch 21, 21' radial mit Bezug auf die Mittellinie 44 geteilt. Hierdurch kann der Magnet 9 so angeordnet werden, daß der magnetische Fluß gezielt auf die Hohlschraube 20 und auf den Polschuh 14 verteilt werden kann. Hierdurch kann man ein homogenes, horizontales Magnetfeld im Targetraum 84 erhalten. Dieses Magnetfeld ist dann ebenfalls durch die Spulen 76, 77, wie bereits erläutert, gezielt beeinflußbar. Wie aus Fig. 5 hervorgeht, ist der Radius R₉ zwischen der Mittellinie 44 und dem Magneten 9 veränderbar oder so einstellbar, daß sich ein optimales Magnetfeld 42 einstellen kann.

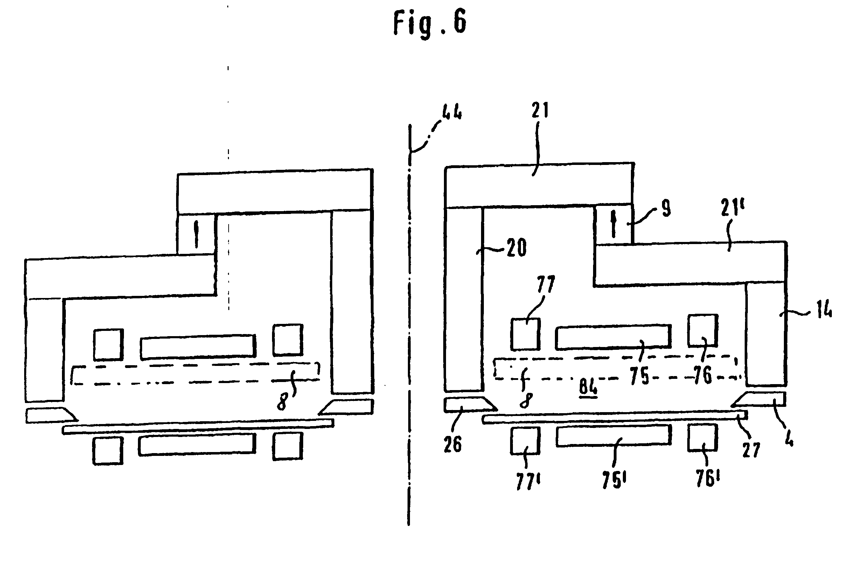

Das Ausführungsbeispiel gemäß Fig. 6 unterscheidet sich vom Ausführungsbeispiel gemäß Fig. 5 dadurch, daß ein zweites Abschirmteil 75' mit zwei ringförmigen Spulen 76', 77' in der gleichen Anordnung wie in Fig. 5 sich außerhalb des Targetraums 84 befindet. Die zusätzliche Schirmplatte 75 im Targetraum 84 oder außerhalb des Targetraums 84 mit den beiden Spulen 76, 77 bzw. 76', 77' dient dazu, das Magnetfeld gezielt und noch optimaler zu beeinflussen. Hierdurch wird die Linsenform der Flußlinien (vgl. Magnetfeld 42) beeinflußt.

Durch die linsenförmige Ausbildung des Magnetfelds 42 gemäß Fig. 3 wird der Einschluß der Elektronen, die zum Ionisieren der Nutzgasatome in der Zerstäubungskammer, z.B. der Argonatome dienen, auf dem Target 8 bewirkt. Das Magnetfeld hält die Elektronen über dem Target 8, die somit nicht auf die Anode abfließen können. Dadurch können die Elektronen auch mehrmals an der Ionisation teilnehmen. Hierdurch wird also zusätzlich gewährleistet, daß eine gleichmäßige Schichtdicke auf der Oberfläche des Substrats 27 erreicht wird.

Durch die beschriebene Anordnung wird unter Berücksichtigung der Strom-Zeit-Funktion (f_{(I)} = I₍ₜ₎) eine optimale Schichtdicken-Gleichmäßigkeit erreicht. Bei dieser Anordnung wird der Strom in Abhängigkeit der Targetoberfläche variiert. Durch unterschiedliches Belegen der Spulen 76, 77 mit Strom erreicht man, daß das Plasma radial oberhalb der Targetoberfläche 41 verschoben werden kann. Das heißt, daß das Plasma mit Bezug auf die Oberfläche des Targets 8 entweder nach links oder rechts verschoben wird. Hierdurch kann die Oberflächenschicht des Substrats 27 gezielt besputtert bzw. aufgebaut werden.

Eine gestufte Ausbildung der Jochplatten 21, 21' ermöglicht einen sehr einfachen, kostengünstigen Aufbau der Kathode insgesamt und auch den Einsatz eines einfachen, ringförmig angeordneten Magneten, der z.B. als Quadermagnet und nicht als Ringmagnet ausgebildet sein kann und auf einfache Weise zwischen die Jochplatten 21, 21' gesetzt werden kann. Ringmagneten sind aufwendiger und daher auch teurer als Quadermagneten.

Die einzelnen Spulen sind unterschiedlich stark beeinflußbar und können je nach Ausführungsbeispiel gekoppelt oder nicht gekoppelt sein. Die Spulen 76, 77 gemäß Figuren 1 und 3 bis 6 können z.B. in Reihe geschaltet werden.

Vorteilhaft ist es, wenn durch die Verwendung der Spulen gemäß Figuren 1 und 3 bis 6, die zum Beispiel unter dem Target oder auch an anderer Stelle wie bereits erläutert, angebracht worden sind, das Magnetfeld im Targetraum gezielt beeinflußt und variiert werden kann, so daß man das Plasma radial von innen nach außen verschieben kann. Hierdurch erreicht man, daß der Erosionsgraben radial über das Target verschoben werden kann, womit man die Möglichkeit hat, einmal einen sehr breiten Erosionsgraben, indem man das Magnetfeld kontinuierlich variiert, oder zwei Erosionsgräben nebeneinander zu erzeugen, indem man das Magnetfeld stufenweise hin- und herschaltet.

Die Schichtdicken-Gleichmäßigkeit kann somit dadurch erreicht werden, daß ein sich zeitlich änderndes Magnetfeld im Bereich der Kathode (Target) hinzugefügt (überlagert) wird. Dieses variable Magnetfeld dient der Schichtdicken-Optimierung über einen Beschichtungszyklus. Hierzu wird eine empirisch zu ermittelnde Strom-Zeit-Funktion für die Ansteuerung der Magnetspulen erstellt.

Die gemäß den Figuren 5 und 6 im Targetinnenraum 84 vorgesehenen Spulen 76, 77 dienen hauptsächlich dazu, das Magnetfeld im Targetraum zu beeinflussen. Um das Magnetfeld außerhalb des Targetraums 84 zu beeinflussen, werden gemäß Fig. 6 die zusätzlichen Spulen 76', 77' und das Schirmblech 75' vorgesehen.

Erfindungsgemäß wird ferner ein Verfahren zum Einstellen der Schichtdicken-Gleichmäßigkeit, einer verbesserten Targetnutzung und Konditionierung der Targetoberfläche zur Verfügung gestellt. Das Verfahren beruht auf einer auf dem Target einstellbaren ortsabhängigen Zerstäubungsenergie, so daß im Stand der Technik übliche Schichtdickeninhomogenitäten am Rande des Substrats vermieden werden können.

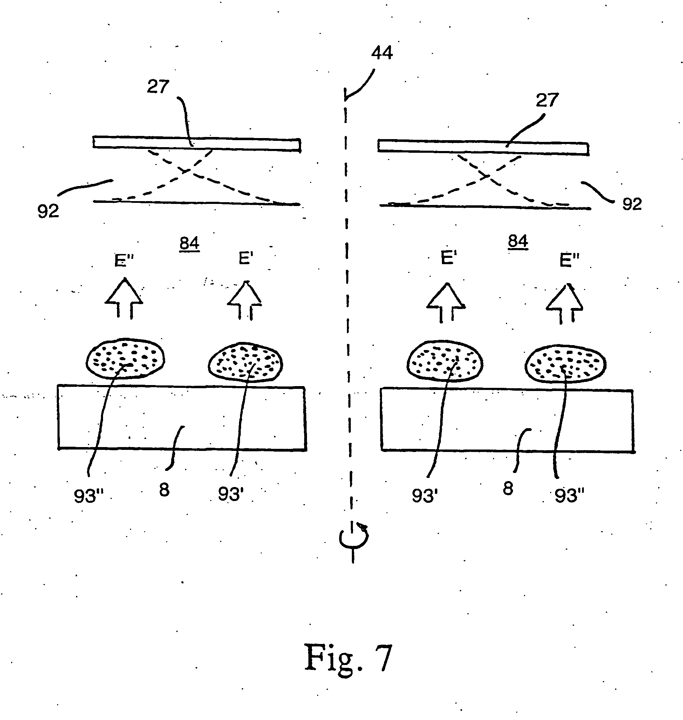

Figur 7 zeigt eine Anordnung, bei der z.B. durch geeignete Ansteuerung der auf der Targetrückseite befindlichen Magnetspulen 76 und 77 auf dem Target 8 an zwei bestimmten Positionen ein innerer Plasmaring 93' und ein äußerer Plasmaring 93" angeordnet wird. Die Plasmaringe 93' und 93" haben eine spezifische Zerstäubungsenergie E' bzw. E". Die durch die unterschiedlichen Zerstäubungsenergien bewirkten unterschiedlichen Abscheidungsraten der Schicht 92 auf dem Substrat 27, deren Schichtauftragungen gestrichelt dargestellt sind, erzeugen in der Überlagerung eine gleichmäßige Dicke der Schicht 92. Während der Abscheidung der Schicht 92 kann das Substrat oder das Target um die Mittelachse 44 rotieren. Das Plasma kann, wie Fig. 7 zeigt, auf zwei oder mehr stationären Positionen oberhalb des Targets (d.h. auf der dem Substrat 27 zugewandten Seite) angeordnet werden. Weiterhin ist es möglich, das Plasma kontinuierlich über das Target zu führen bzw. hin- und herzubewegen (wobbeln). Die Zerstäubungsleistung kann dabei in Abhängigkeit von der Position des Plasmas durch Einstellen des Kathodenstroms und Kathodenspannung geregelt werden. Erfindungsgemäß kann auch ein zur Mittelachse 44 konzentrischer Plasmaring durch Veränderung seines Radius über das Target 8 geführt werden.

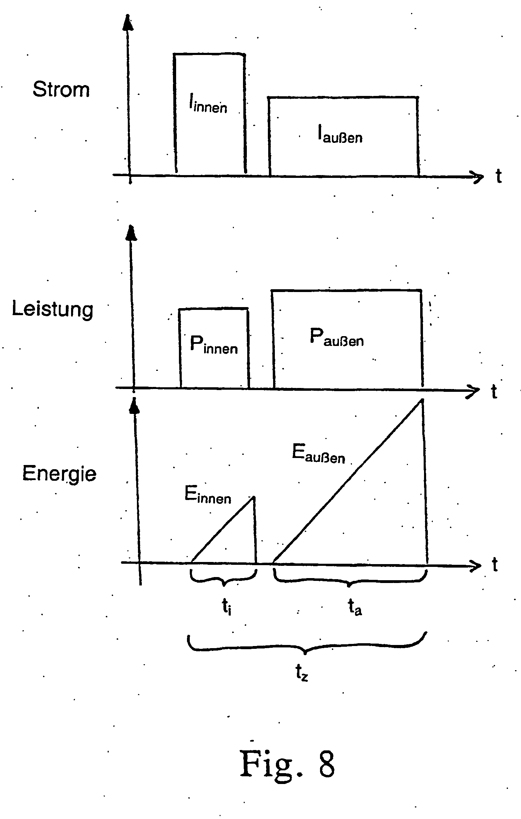

Die Anordnung gemäß Fig. 7 wird in Fig. 8 näher erläutert. In Fig. 8 sind über der Zeitachse (Abszisse) im oberen Diagramm die Erregungsströme einer inneren und einer äußeren Magnetspule (z.B. Spulen 76 und 77 von Fig. 1), im mittleren Diagramm die Zerstäubungsleistungen auf einer inneren und äußeren Position des Targets und im unteren Diagramm die sich ergebenden Zerstäubungsenergien auf der inneren und äußeren Position des Targets dargestellt. Während der Zeit t_{z} eines Beschichtungszyklus wird zuerst die innere Spule während der Zeit tᵢ mit dem elektrischen Strom Iᵢₙₙₑₙ angeregt und ein innerer Plasmaring erzeugt. Gleichzeitig wird durch die Spannung zwischen Kathode und Anode die Zerstäubungsleistung Pᵢₙₙₑₙ auf der inneren Targetposition eingestellt, die über die Zeit tᵢ zu einem Anstieg der Zerstäubungsenergie Eᵢₙₙₑₙ führt. Nach Ablauf der Zeit tᵢ wird die innere Magnetspule abgeschaltet und die äußere Magnetspule während der Zeit tₐ erregt und ein äußerer Plasmaring erzeugt. Gleichzeitig wird durch die Spannung zwischen Kathode und Anode die Zerstäubungsleistung P_{außen} auf der äußeren Plasmaposition eingestellt, die über die Zeit tₐ zu einem Anstieg der Zerstäubungsenergie E_{außen} führt. Nach dem Abschalten der äußeren Magnetspule ist der Beschichtungszyklus abgeschlossen.

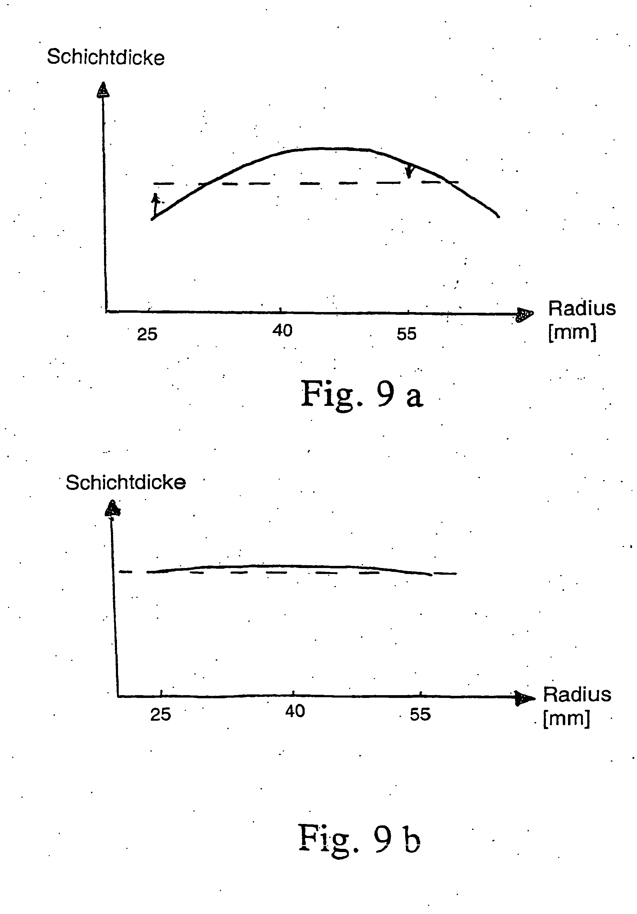

Der Einfluß der ortsabhängigen Zerstäubungsenergie auf dem Target 8 auf die Schichtdicke ergibt sich durch Vergleich der Figuren 9a und 9b. In den Figuren ist die Dicke der Schicht 92 auf dem Substrat von innen nach außen in Richtung des Radius aufgetragen. Ohne das erfindungsgemäße Verfahren ergibt sich ein Verlauf der Schichtdicke, wie er in Fig. 9a dargestellt ist. Mit dem erfindungsgemäßen Verfahren kann die Schichtdicke weitgehend homogenisiert werden, wie in Fig. 9b zu sehen ist.

Das erfindungsgemäße Verfahren der ortsabhängigen zerstäubungsenergie wirkt sich auch auf die Targetausnutzung und die Konditionierung der Targetoberfläche sehr günstig aus.

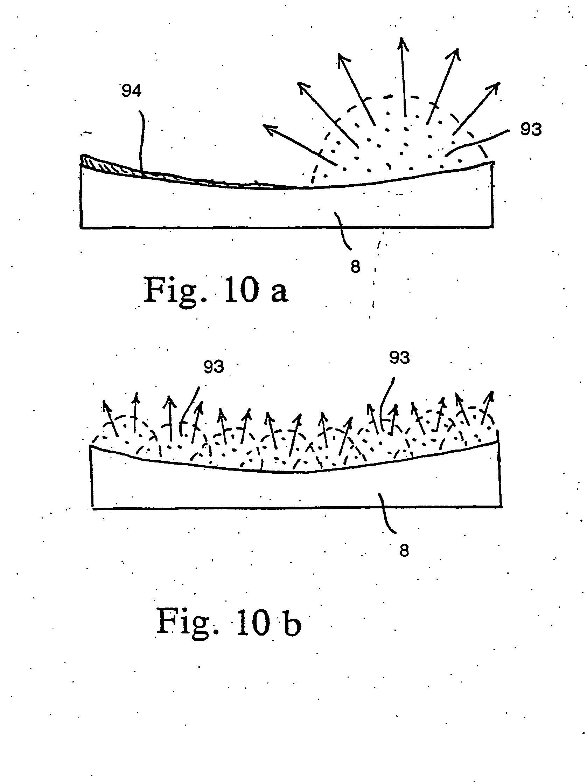

Fig. 10a. zeigt, daß bei einer geringen Zerstäubungsenergie am Rand eines Targets eine Rückbeschichtung auftreten kann. Dabei können unerwünschte kornartige Strukturen auftreten.

In Fig. 10b ist dargestellt, daß mit dem erfindungsgemäßen Wandern des Plasmas 92 über das Target 8 eine Rückbeschichtung am Rande vermieden wird.

Insbesondere kann eine Rückbeschichtung 94 auf dem Target dadurch verhindert werden, daß man die Zerstäubungsmenge in einem Prozeßzyklus mindestens so groß einstellt wie die Menge der Rückbeschichtung. Die Reaktivität des Zerstäubungsprozesses hängt dabei von der Leistungsdichte an der Targetoberfläche ab. Bei gleicher Zerstäubungsleistung ist auf einer kleineren Targetfläche die Leistungsdichte höher als auf einer größeren Targetfläche. Ist die Leistungsdichte zu hoch, wird der Prozeß metallisch, d.h. es wird nur das metallische Target zerstäubt, so daß ein reaktives Zerstäuben nicht eintritt. Die Leistungsdichte muß also der entsprechenden Targetoberfläche angepaßt werden. Das geschieht erfindungsgemäß durch geeignete Ansteuerung der Magnetspulen und geeignete Einstellung der Kathoden-/Anodenspannung. Das erfindungsgemäße Verfahren ermöglicht eine hohe Schichtdickengleichmäßigkeit auch bei einem geringen Target-Substrat-Abstand und bei dicken Targets.

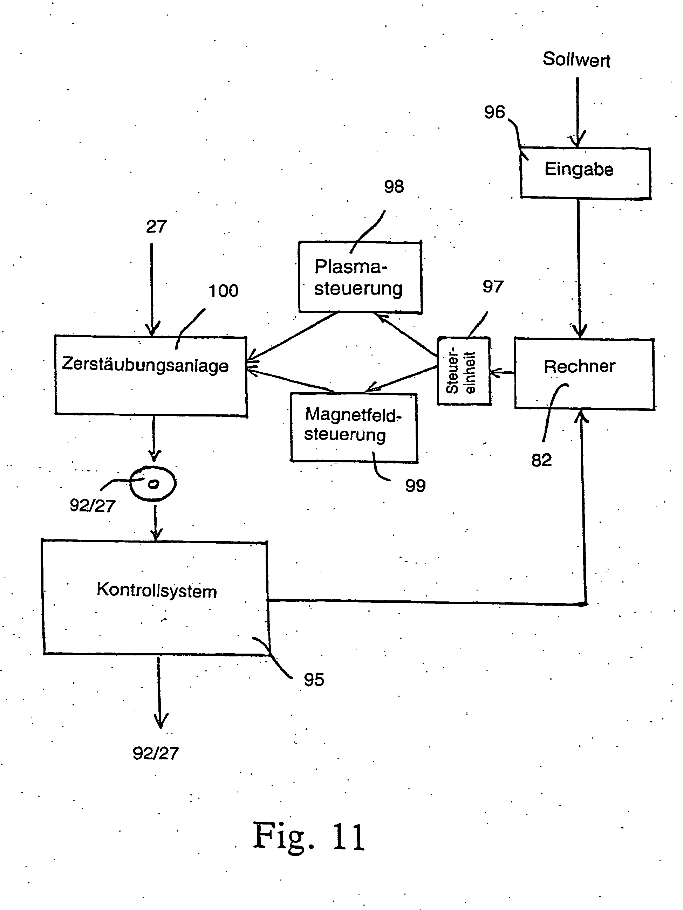

Fig. 11 zeigt einen Regelkreis, mit dem erfindungsgemäß durch Vermessen eines Substrats und seiner Beschichtung die Prozeßparameter für den oder die nachfrolgenden Beschichtungszyklus bzw. -zyklen eingestellt werden können,um die Schichtdicke und die Schichtdicken-Gleichmäßigkeit zu regeln.

Ein Substrat 27 wird nach dem Auftragen einer Schicht 92 einem Kontrollsystem 95 zugeführt, das Messungen der Schichtdicke bzw. der Schichtdickenverteilung vornimmt. Das Resultat wird dem Rechner 82 gemeldet, der diesen Wert mit einem Sollwert vergleicht, der z.B. von einem Operator über die Eingabe 96 eingegeben werden kann. Der Rechner berechnet einen Korrekturwert für die Schichtdicke, wenn keine Übereinstimmung zwischen gemessenem und Sollwert besteht. Der Korrekturwert wird einer Steuereinheit 97 gemeldet, die die Plasmastromversorgung 98 und die Magnetfeldablenkung 99 steuert, um die Schichtdicke auf dem nächsten zu beschichtenden Substrat 27 in der Zerstäubungsanlage 100 nachzuregeln.

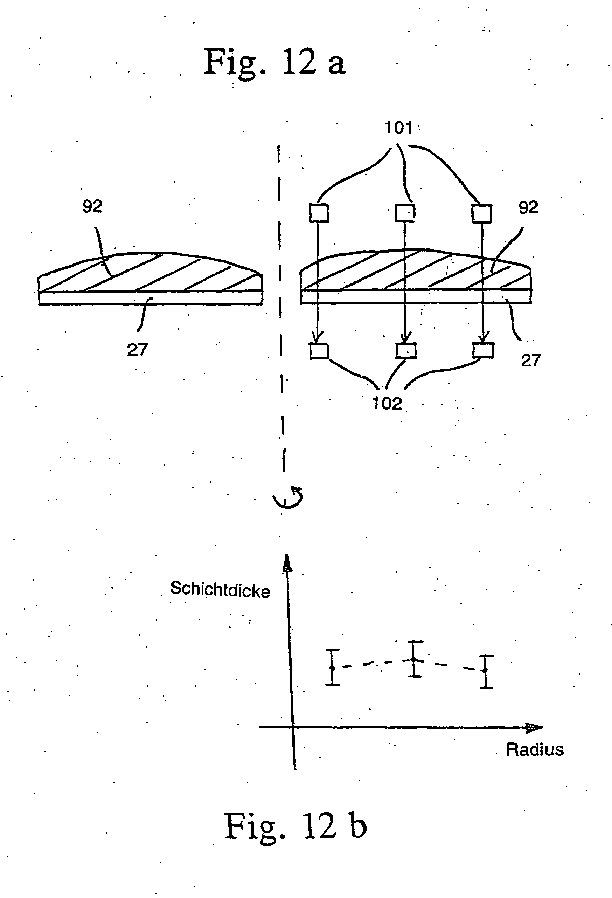

Fig. 12a zeigt ein Beispiel einer Meßanordnung zur Schichtdickenbestimmung von zylindersymmetrischen Substraten. Drei oder mehr Leuchtdioden 101 sind oberhalb der Schicht 92 angeordnet. Unterhalb des Substrats 27 befinden sich drei oder mehr den Leuchtdioden zugeordnete Photosensoren 102. Aus der gemessenen Transmission des Lichtes, die der. Dicke der Schicht 92 bei konstanter Substratdicke umgekehrt proportional ist, läßt sich dann die Schichtdicke bestimmen.

Entsprechende Transmissionswerte über den Radius, die die Schichtdicke repräsentieren, sind in Fig. 12b dargestellt. Zur Mittelung von Streuwerten (Fehlerbereiche sind schematisch mit vertikalen Fehlerbalken eingetragen) wird das beschichtete Substrat während des Messens um die Mittelachse 44 gedreht.

Die Messung kann auch in Reflexion erfolgen.

Es besteht auch die Möglichkeit, daß die Messung der Schichtdicke während des Beschichtungsprozesses erfolgt und die Schichtdicke während des Beschichtungsprozesses geregelt wird.

Das erfindungsgemäße Verfahren hat den Vorteil, daß eine kontinuierliche Anpassung der Beschichtung, der Targetausnutzung und der Targetkonditionierung erfolgen kann.

## Patentansprüche

1. Verfahren zum Beschichten von Substraten (27) durch Magnetron-Kathodenzerstäubung mittels einer in einer Vakuumkammer angeordneten Zerstäubungskathode (2) mit Polschuhen (14), einem Target (8) und einem ringförmigen Magnetron-Magnetfeld im Bereich der Targetoberfläche, das durch Überlagerung eines statischen RingMagnetfeldes eines Ringmagneten (14, 9, 21) mit einem veränderbaren Magnetfeld einer Spulenanordnung (76, 77) stufenweise und/oder kontinuierlich veränderbar ist, **dadurch gekennzeichnet, dass** das veränderbare Magnetfeld durch eine zwischen dem Ringmagneten (14, 9, 21) und dem Target (8) vorgesehene Spulenanordnung (76, 77) erzeugt wird.

2. Verfahren nach Anspruch 1, wobei das Magnetfeld während der Beschichtung verändert wird.

3. Verfahren nach Anspruch 1 oder 2, wobei das Magnetfeld zwischen zwei Beschichtungszyklen verändert wird.

4. Verfahren nach einem der Ansprüche 1 bis 3, wobei das veränderbare Magnetfeld nach einem vorgegebenen Verlauf gesteuert wird.

5. Verfahren nach einem der Ansprüche 1 bis 4 unter Verwendung von Sensoren zur Ermittlung der Schichtdicke auf dem Substrat, der Form der Targetoberfläche und/oder des Magnetfeldes, wobei das Magnetfeld unter Berücksichtigung der Sensorausgangssignale gesteuert wird.

6. Verfahren nach einem der Ansprüche 1 bis 5, wobei die Beschichtung des Substrats (27) durch Einstellen einer auf dem Target (8) ortsabhängigen Zerstäubungsenergie (E', E") gesteuert wird.

7. Verfahren nach Anspruch 6, wobei die Zerstäubungsleistung in Abhängigkeit der Position des Plasmas (93) geregelt wird.

8. Verfahren nach Anspruch 6 oder 7, wobei das Plasma (93) auf mindestens eine Position gegenüber dem Target (8) eingestellt wird.

9. Verfahren nach Anspruch 8, wobei die Positionierung des Plasmas (93) durch die Magnetspulen (76, 77) auf der Targetrückseite (40) erfolgt.

10. Verfahren nach Anspruch 6, 7, 8 oder 9, wobei das Plasma kontinuierlich über das Target (8) geführt wird.

11. Verfahren nach einem der Ansprüche 6 bis 10, wobei gegenüber dem Target (8) ein innerer (93') und ein äußerer Plasmaring (93'') angeordnet wird.

12. Verfahren nach Anspruch 10, wobei ein bezüglich einer Mittelachse (44) konzentrischer Plasmaring durch Veränderung seines Radius über das Target (8) geführt wird.

13. Verfahren nach einem der Ansprüche 1 bis 12, wobei das statische Ringmagnetfeld durch mindestens einen Ringmagneten (9) im Bereich der Jochplatte (21, 21') oder im Bereich des Außenumfangs der Jochplatte (21, 21') erzeugt wird.

14. Verfahren nach einem der Ansprüche 1 bis 13, wobei der Targetraum (84) zwischen dem Target (8) und dem Substrat (27) gegen Kurzschlussfeldlinien des statischen Magnetfeldes mittels eines Eisenkerns (75) zwischen den beiden Spulen (76, 77) abgeschirmt wird.

15. Verfahren nach Anspruch 14, wobei das veränderbare Magnetfeld mittels des Eisenkerns (75) verstärkt wird.

16. Vorrichtung zum Beschichten von Substraten (27) durch Magnetron-Kathodenzerstäubung, mit
(a) einer in einer Vakuumkammer , angeordneten Zerstäubungskathode (2) mit Polschuhen (14) und einem Target (8),
(b) einem Ringmagneten (14, 9, 21) zum Erzeugen eines statischen Ringmagnetfeldes im Bereich der Oberfläche (41) des Targets (8) und
(c) einer Spulenanordnung zum Erzeugen eines veränderbaren Magnetfeldes, das dem statischen Ring-Magnetfeld überlagerbar ist,
**dadurch gekennzeichnet, dass**
(d) die Spulenanordnung (76, 77) zwischen dem Ringmagneten (14, 9, 21) und dem Target (8) angeordnet ist.

17. Vorrichtung nach Anspruch 16, wobei Sensoren zum Ermitteln der Schichtdicke auf dem Substrat (27), der Form der Targetoberfläche (41) und/oder des Magnetfeldes vorgesehen sind.

18. Vorrichtung nach Anspruch 16 oder 17, wobei zwischen dem Target (8) oder zwischen Targetrückseite (40) und einer Jochplatte (21, 21') mindestens eine erste Spule oder ringförmig angeordnete Spule (76, 77) vorgesehen ist.

19. Vorrichtung nach einem der Ansprüche 16 bis 18, wobei im Bereich der Jochplatte (21) oder im Bereich des Außenumfangs der Jochplatte (21) mindestens ein Ringmagnet (9) vorgesehen ist.

20. Vorrichtung nach einem der Ansprüche 16 bis 19, wobei im Bereich des Außenumfangs (55) des Targets (8) die erste Magnetspule (76) und im Bereich des Innenumfangs (54) des Targets (8) eine zweite Magnetspule (77) vorgesehen ist.

21. Vorrichtung nach Anspruch 20, wobei die erste und zweite Magnetspule (76, 77) oberhalb der oberen Begrenzung (57) oder der Rückseite (40) des Targets (8) vorgesehen sind.

22. Vorrichtung nach Anspruch 20 oder 21, wobei die erste und die zweite Magnetspule (76, 77) in der gleichen Querebene angeordnet sind.

23. Vorrichtung nach einem der Ansprüche 20 bis 22, wobei die erste und die zweite Magnetspule (76, 77) in der gleichen Querebene zwischen einer ersten oder zweiten Jochplatte (21, 21') und der Rückseite (40) des Targets (8) angeordnet sind.

24. Vorrichtung nach einem der Ansprüche 19 bis 23, wobei der im Bereich des Außenumfangs des ersten und/oder zweiten Jochs bzw. der Jochplatte (21, 21') vorgesehene Ringmagnet (9) zwischen einer unteren bzw. ersten Jochplatte (21') und einer oberen bzw. zweiten Jochplatte (21) vorgesehen ist.

25. Vorrichtung nach einem der Ansprüche 19 bis 24, wobei die beiden Magnetspulen (76, 77) und der Ringmagnet (9) konzentrisch zur Mittelachse (44) der Zerstäubungskathode (2) angeordnet sind.

26. Vorrichtung nach einem der Ansprüche 19 bis 25, wobei der Ringmagnet (9) einen Außendurchmesser aufweist, der in etwa gleich, kleiner oder größer als der Außendurchmesser der ersten Spule (76) ist.

27. Vorrichtung nach einem der Ansprüche 18 bis 26, wobei in einem zwischen Target (8) und mindestens einer Jochplatte (21, 21') vorgesehenen Isolator (6) und/oder dem Target (8) Ringkammern (86) zur Aufnahme der Spule oder der ringförmig angeordneten Spulen (76, 77) vorgesehen sind.

28. Vorrichtung nach einem der Ansprüche 18 bis 27, wobei die zwei Spulen oder ringförmig angeordneten Spulen (76, 77) unterschiedlich große Durchmesser aufweisen.

29. Vorrichtung nach Anspruch 28, wobei die zweite ringförmig angeordnete Spule (77) einen kleineren Außendurchmesser aufweist als die erste Spule (76).

30. Vorrichtung nach einem der Ansprüche 19 bis 29, wobei der Ringmagnet (9) eine in Richtung des Substrates (27) zeigende N/S-Polung aufweist.

31. Vorrichtung nach einem der Ansprüche 18 bis 30, wobei ein Abschirmteil (75) zwischen den beiden Spulen (76, 77) vorgesehen ist.

32. Vorrichtung nach Anspruch 31, wobei das Abschirmteil (75) zwischen einer der Jochplatten (21, 21') und dem Target (8) vorgesehen ist.

33. Vorrichtung nach Anspruch 31, wobei das Abschirmteil (75) zwischen einer der Jochplatten (21, 21') und/oder einem Isolator (6) und dem Target (8) vorgesehen ist.

34. Vorrichtung nach einem der Ansprüche 18 bis 33, wobei die beiden Jochplatten (21, 21') in Richtung der Mittelachse (44) mit Abstand zueinander angeordnet sind.

35. Vorrichtung nach Anspruch 34, wobei der Abstand zwischen den beiden Jochplatten (21, 21') in etwa der Höhe des Ringmagneten (9) entspricht.

36. Vorrichtung nach Anspruch 34 oder 35, wobei die beiden Jochplatten (21, 21') unterschiedlich große Außendurchmesser aufweisen bzw. in Form einer Treppenstufe angeordnet sind.

37. Vorrichtung nach Anspruch 36, wobei die im Außendurchmesser kleinere Jochplatte (21) mit dem Kühlfinger (74) und die im Außendurchmesser größere Jochplatte (21') mit dem Polschuh (14) mittel- oder unmittelbar verbunden ist.

38. Vorrichtung nach einem der Ansprüche 16 bis 37, wobei der an die Spulen (76, 77) angelegte Strom in Abhängigkeit von der Zeit veränderbar ist.

39. Vorrichtung nach einem der Ansprüche 16 bis 38, wobei der an die Spulen (76, 77) angelegte Strom bzw. die Stromzufuhr zu den Spulen über eine Steuerkurve bzw. über ein vorab festgelegtes Programm steuerbar ist und die Stromzufuhrleitungen (78, 79) hierzu über einen Stromteiler (80) mit einem Rechner (82) in Wirkverbindung stehen.

40. Vorrichtung nach einem der Ansprüche 16 bis 39, wobei in Richtung der Mittelachse (44) die erste Magnetspule (76) oberhalb der Jochplatte (21') und die zweite Magnetspule (77) unterhalb der Jochplatte (21) angeordnet ist.

41. Vorrichtung nach einem der Ansprüche 16 bis 40, wobei ein zweites Abschirmteil (75') und zwei zweite ringförmige Magnetspulen (76', 77') außerhalb des Targetraumes (84) angeordnet sind.

42. Vorrichtung nach Anspruch 41, wobei das zweite Abschirmteil (75') und die zweiten Magnetspulen (76', 77') spiegelsymmetrisch zu dem ersten Abschirmteil (75) und den Magnetspulen (76, 77) unterhalb des Substrats (27) angeordnet sind.

43. Verfahren nach einem der Ansprüche 6 bis 15, wobei
(a) zum Überwachen der Parameter der Schicht (92) ein Kontrollsystem (95),
(b) zur Berechnung von Korrekturwerten, wenn die Parameter der Schicht (92) von Sollwerten abweichen, eine Rechnereinheit (82) und
(c) zum Steuern der Beschichtung in Abhängigkeit von den Korrekturwerten eine Steuereinheit (97) benutst wird.

44. Verfahren nach Anspruch 43 , wobei zum Messe der parameter, wie Reflexion, Transmission und die optische Dichte der Schicht (92), an vorgegeben Stellen des Substrats (27) das Kontrollsystem (95) eine Messanordhung aufweist.

45. Verfahren nach Anspruch 44, wobei zum Messen der Transmission des von den Leuchtdioden ausgesandten Lichtes oberhalb der Schicht (92) Leuchtdioden (101) und unterhalb des Substrats (27) Photodetektoren (102) angeordnet sind.

46. Verfahren nach einem der Ansprüche 43 bis 45, wobei die Schichtparameter während der Beschichtung gemessen und danach die Beschichtungsparameter, wie Zerstäubungsleistung, Zerstäubungszeit und Magnetfeld, geregelt werden.

47. Verfahren nach einem der Ansprüche 43 bis 46, wobei die Schichtparameter nach Beendigung der Beschichtung eines Substrats gemessen werden und aufgrund der Messergebnisses die Verfahrensparameter bei einer nachfolgenden Beschichtung eingestellt werden.

48. Verfahren nach Anspruch 46 oder 47 mit den Schritten:
(a) Messen der Schichtparameter,
(b) Zuführen der Messwerte zur Rechnereinheit (82),
(c) Berechnen von Korrekturwerten für den Beschichtungsprozess anhand von vorgegebenen Sollwerten, und
(d) Steuern des Beschichtungsprozesses auf der Grundlage der Korrekturwerte.

49. Verfahren nach Anspruch 48, wobei in Schritt (a) die Schichtparameter während des Rotierens des Substrates (27) um eine Mittelachse gemessen und gemittelt werden.

## Claims

1. A method for coating substrates (27) by magnetron cathode sputtering by means of a sputtering cathode (2) arranged in a vacuum chamber and comprising pole shoes (14), a target (8) and a ring-shaped magnetron magnetic field in the area of the surface of the target, which can be varied stepwise and/or continuously in that a variable magnetic field of a coil arrangement (76, 77) superimposes a static annular magnetic field of a ring magnet (14, 9, 21), **characterized in that** the variable magnetic field is generated by a coil arrangement (76, 77) provided between the ring magnet (19, 9, 21) and the target (8).

2. The method according to claim 1, wherein the magnetic field is varied during the coating process.

3. The method according to claim 1 or 2, wherein the magnetic field is varied between two coating cycles.

4. The method according to any one of claims 1 to 3, wherein the variable magnetic field is controlled in accordance with a preset course.

5. The method according to any one of claims 1 to 4 using sensors for determining the coating thickness on the substrate, the shape of the target surface and/or the shape of the magnetic field, wherein the magnetic field is controlled in accordance with the sensor output signals.

6. The method according to any one of claims 1 to 5, wherein the coating of the substrate (27) is controlled by adjusting a position-dependent sputtering energy (E', E") on the target (8).

7. The method according to claim 6, wherein the sputtering power is controlled depending on the position of the plasma (93).

8. The method according to claim 6 or 7, wherein the plasma (93) is adjusted to at least one position opposite the target (8).

9. The method according to claim 8, wherein the positioning of the plasma (93) is performed by the magnetic coils (76, 77) arranged on the back surface (40) of the target.

10. The method according to claim 6, 7, 8 or 9, wherein the plasma is moved continuously over the target (8).

11. The method according to any one of claims 6 to 10, wherein an inner plasma ring (93') and an outer plasma ring (93") are arranged opposite the target (8).

12. The method according to claim 10, wherein a plasma ring being concentrical with respect to a center axis (44) is moved over the target (8) by varying its radius.

13. The method according to any one of claims 1 to 12, wherein the static annular magnetic field is generated by at least one ring magnet (9) in the area of the yoke plate (21, 21') or in the area of the outer circumference of the yoke plate (21, 21').

14. The method according to any one of claims 1 to 13, wherein the target space (84) between the target (8) and the substrate (27) is shielded against short circuit field lines of the static magnetic field by means of an iron core (75) between the two coils (76, 77).

15. The method according to claim 14, wherein the variable magnetic field is increased by the iron core (75).

16. A device for coating substrates (27) by magnetron cathode sputtering comprising
(a) a sputtering cathode (2) arranged in a vacuum chamber and comprising pole shoes (14) and a target (8),
(b) a ring magnet (14, 9, 21) for generating a static annular magnetic field in the area of the surface (41) of the target (8) and
(c) a coil arrangement for generating a variable magnetic field which can superimpose the static annular magnetic field,
**characterized in that**
(d) the coil arrangement (76, 77) is arranged between the ring magnet (14, 9, 21) and the target (8).

17. The device according to claim 16, wherein sensors for determining the coating thickness on the substrate (27), the shape of the target surface (41) and/or the shape of the magnetic field are provided.

18. The device according to claim 16 or 17, wherein at least one first coil or annularly arranged coil (76, 77) is provided between the target (8) or between the back surface (40) of the target and a yoke plate (21, 21').

19. The device according to any one of claims 16 to 18, wherein at least one ring magnet (9) is provided in the area of the yoke plate (21) or in the area of the outer circumference of the yoke plate (21).

20. The device according to any one of claims 16 to 19, wherein the first magnetic coil (76) is provided in the area of the outer circumference (55) of the target (8) and a second magnetic coil (77) is provided in the area of the inner circumference (54) of the target (8).

21. The device according to claim 20, wherein the first and second magnetic coils (76, 77) are provided above the upper limit (57) or the back surface (40) of the target (8).

22. The device according to claim 20 or 21, wherein the first and the second magnetic coils (76, 77) are arranged in the same transverse plane.

23. The device according to any one of claims 20 to 22, wherein the first and the second magnetic coils (76, 77) are arranged in the same transverse plane between a first or second yoke plate (21, 21') and the back surface (40) of the target (8).

24. The device according to any one of claims 19 to 23, wherein the ring magnet (9) provided in the area of the outer circumference of the first and/or second yoke or yoke plate (21, 21') is arranged between a lower or first yoke plate (21') and an upper or second yoke plate (21).

25. The device according to any one of claims 19 to 24, wherein the two magnetic coils (76, 77) and the ring magnet (9) are arranged concentrically with respect to the center axis (44) of the sputtering cathode (2).

26. The device according to any one of claims 19 to 25, wherein the ring magnet (9) has an outer diameter which is about as large as, smaller or larger than the outer diameter of the first coil (76).

27. The device according to any one of claims 18 to 26, wherein ring chambers (86) for receiving the coil or the annularly arranged coils (76, 77) are provided in an insulator (6), which is provided between the target (8) and at least one yoke plate (21, 21'), and/or in the target (8).

28. The device according to any one of claims 18 to 27, wherein the two coils or annularly arranged coils (76, 77) have different diameters.

29. The device according to claim 28, wherein the second annularly arranged coil (77) has a smaller outer diameter than the first coil (76).

30. The device according to any one of claims 19 to 29, wherein the ring magnet (9) has an N/S polarity directed towards the substrate (27).

31. The device according to any one of claims 18 to 30, wherein a shielding means (75) is provided between the two coils (76, 77).

32. The device according to claim 31, wherein the shielding means (75) is provided between one of the yoke plates (21, 21') and the target (8).

33. The device according to claim 31, wherein the shielding means (75) is provided between one of the yoke plates (21, 21') and/or an insulator (6) and the target (8).

34. The device according to any one of claims 18 to 33, wherein the two yoke plates (21, 21') are spaced from each other in the direction of the center axis (44).

35. The device according to claim 34, wherein the distance between the two yoke plates (21, 21') corresponds to approximately the height of the ring magnet (9).

36. The device according to claim 34 or 35, wherein the two yoke plates (21, 21') have different outer diameters or are arranged in the form of a step.

37. The device according to claim 36, wherein the yoke plate (21) having a smaller outer diameter is connected with the cooling finger (74) and the yoke plate (21') having a larger outer diameter is connected indirectly or directly with the pole shoe (14).

38. The device according to any one of claims 16 to 37, wherein the current fed to the coils (76, 77) can be varied depending on time.

39. The device according to any one of claims 16 to 38, wherein the current fed to the coils (76, 77) or the current supply to the coils can be controlled via a control curve or a preset program and that for this purpose current conductors (78, 79) are in an operating connection with a computer (82) via a current divider (80).

40. The device according to any one of claims 16 to 39, wherein in the direction of the center axis (44) the first magnetic coil (76) is arranged above the yoke plate (21') and the second magnetic coil (77) is arranged below the yoke plate (21).

41. The device according to any one of claims 16 to 40, wherein a second shielding means (75') and two second ring-shaped magnetic coils (76', 77') are arranged outside the target space (84).

42. The device according to claim 41, wherein the second shielding means (75') and the second magnetic coils (76', 77') are arranged mirror-symmetrically with respect to the first shielding means (75) and the magnetic coils (76, 77) below the substrate (27).

43. The method according to any one of claims 6 to 15, wherein
(a) a control system (95) is used for controlling the parameters of the coating (92),
(b) a computing unit (82) is used for calculating correction values if the parameters of the coating (92) differ from desired values, and
(c) a control unit (97) is used for controlling the coating in accordance with the correction values.

44. The method according to claim 43, wherein the control system (95) comprises a measuring arrangement for measuring the parameters, such as reflection, transmission and the optical density of the coating (92) at predetermined positions of the substrate (27).

45. The method according to claim 44, wherein light-emitting diodes (101) are arranged above the coating (92) and photo detectors (102) are arranged below the substrate (27) for measuring the transmission of the light emitted by the light-emitting diodes.

46. A method according to any one of claims 43 to 45, wherein the coating parameters are measured during the coating process and subsequently the coating parameters, such as sputtering power, sputtering time and magnetic field are controlled.

47. A method according to any one of claims 43 to 46, wherein the coating parameters are measured after the coating of a substrate is finished and that in a subsequent coating process the process parameters are adjusted on the basis of the measuring result.

48. The method according to claim 46 or 47 comprising the steps of
(a) measuring the coating parameters,
(b) supplying the measuring values to the computing unit (82),
(c) calculating correction values for the coating process on the basis of preset desired values, and
(d) controlling the coating process on the basis of the correction values.

49. The method according to claim 48, wherein in step (a) the coating parameters are measured and the average is taken therefrom while the substrate (27) rotates around a center axis.

## Revendications

1. Procédé d'enduction de substrats (27) par pulvérisation cathodique magnétron à l'aide d'une cathode de pulvérisation (2) placée dans une chambre à vide avec des pièces polaires (1-4), une cible (8) et un champ magnétique de magnétron en anneau au niveau de la surface de la cible, ce champ étant modifiable graduellement et/ou continuellement par la superposition d'un champ magnétique annulaire statique d'un aimant en anneau (14, 9, 21) avec un champ magnétique modifiable d'un dispositif de bobines (76, 77), **caractérisé en ce que** le champ magnétique modifiable est créé par un dispositif de bobines (76, 77) prévu entre l'aimant en anneau (14, 9, 21) et la cible (8).

2. Procédé selon la revendication 1, dans lequel le champ magnétique est modifié durant l'enduction.

3. Procédé selon la revendication 1 ou 2, dans lequel le champ magnétique est modifié entre deux cycles d'enduction.

4. Procédé selon l'une des revendications 1 à 3, dans lequel le champ magnétique modifiable est commandé suivant un déroulement prédéfini.

5. Procédé selon l'une des revendications 1 à 4 avec l'utilisation de détecteurs pour déterminer l'épaisseur de couche sur le substrat, la forme de la surface de la cible et/ou du champ magnétique, dans lequel le champ magnétique est commandé en fonction des signaux venant de ces détecteurs.

6. Procédé selon l'une des revendications 1 à 5, dans lequel l'enduction du substrat (27) est commandée en ajustant l'énergie de pulvérisation (E', E") en fonction de la localisation de la cible (8).

7. Procédé selon la revendication 6, dans lequel la puissance de pulvérisation est réglée en fonction de la position du plasma (93).

8. Procédé selon la revendication 6 ou 7, dans lequel le plasma (93) est ajusté sur au moins une position en face de la cible (8).

9. Procédé selon la revendication 8, dans lequel le positionnement du plasma (93) s'effectue à l'aide de bobines d'excitation (76, 77) sur le côté arrière de la cible (40).

10. Procédé selon l'une des revendications 6, 7, 8 ou 9, dans lequel le plasma est mené de manière continue sur la cible (8).

11. Procédé selon l'une des revendications 6 à 10, dans lequel un anneau interne (93') et externe (93'') de plasma est agencé face à la cible (8).

12. Procédé selon la revendication 10, dans lequel un anneau de plasma concentrique par rapport un axe central (44) est mené sur la cible (8) en modifiant son rayon.

13. Procédé selon l'une des revendications 1 à 12, dans lequel le champ magnétique annulaire statique est créé par au moins un aimant en anneau (9) au niveau de la plaque de culasse (21, 21') ou au niveau du périmètre extérieur de la plaque de culasse (21, 21').

14. Procédé selon l'une des revendications 1 à 13, dans lequel l'espace de cible (84) qui se trouve entre la cible (8) et le substrat (27) est blindé contre des lignes de champ de court-circuit du champ magnétique statique à l'aide d'un noyau en fer (75) qui est placé entre les deux bobines (76, 77).

15. Procédé selon la revendication 14, dans lequel le champ magnétique modifiable est renforcé à l'aide du noyau en fer (75).

16. Dispositif pour enduire des substrats (27) par pulvérisation cathodique magnétron avec
(a) une cathode de pulvérisation (2) placée dans une chambre à vide avec des pièces polaires (14) et une cible (8)
(b) un aimant en anneau (14, 9, 21) pour créer un champ magnétique annulaire statique au niveau de la surface (41) de la cible (8) et
(c) un dispositif de bobines pour créer un champ magnétique modifiable pouvant être superposé au champ magnétique annulaire statique,
**caractérisé en ce que**
(d) le dispositif de bobines (76, 77) est agencé entre l'aimant en anneau (14, 9, 21) et la cible (8).

17. Dispositif selon la revendication 16, dans lequel des détecteurs sont prévus pour déterminer l'épaisseur de couche sur le substrat (27), la forme de la surface de la cible (41) et/ou du champ magnétique.

18. Dispositif selon la revendication 16 ou 17, dans lequel au moins une première bobine ou une bobine agencée en forme d'anneau (76, 77) est prévue entre la cible (8) ou entre le côté arrière de la cible (40) et une plaque de culasse (21, 21').

19. Dispositif selon l'une des revendications 16 à 18, dans lequel au moins un aimant en anneau (9) est prévu au niveau de la plaque de culasse (21) ou au niveau du périmètre extérieur de la plaque de culasse (21).

20. Dispositif selon l'une des revendications 16 à 19, dans lequel la première bobine d'excitation (76) est prévue au niveau du périmètre extérieur (55) de la cible (8), une seconde bobine d'excitation (77) est prévue au niveau du périmètre intérieur (54) de la cible (8).

21. Dispositif selon la revendication 20, dans lequel la première et la seconde bobine d'excitation (76, 77) sont prévues au dessus de la délimitation supérieure (57) ou du côté arrière (40) de la cible (8).

22. Dispositif selon la revendication 20 ou 21, dans lequel la première et la seconde bobine d'excitation (76, 77) sont agencées dans le même plan transversal.

23. Dispositif selon l'une des revendications 20 à 22, dans lequel la première et la seconde bobine d'excitation (76, 77) sont agencées dans le même plan transversal entre une première ou une seconde plaque de culasse (21, 21') et le côté arrière (40) de la cible (8).

24. Dispositif selon l'une des revendications 19 à 23, dans lequel l'aimant en anneau (9) prévu au niveau du périmètre extérieur de la première et/ou de la seconde culasse ou bien de la plaque de culasse (21, 21') est prévu entre une plaque de culasse inférieure (21') ou bien première et une plaque de culasse supérieure (21) ou bien seconde.

25. Dispositif selon l'une des revendications 19 à 24, dans lequel les deux bobines d'excitation (76, 77) et l'aimant en anneau (9) sont agencés de manière concentrique par rapport à l'axe central (44) de la cathode de pulvérisation (2).

26. Dispositif selon l'une des revendications 19 à 25, dans lequel l'aimant en anneau (9) présente un diamètre extérieur qui est à peu près égal, inférieur ou supérieur au diamètre extérieur de la première bobine (76).

27. Dispositif selon l'une des revendications 18 à 26, dans lequel des chambres en anneau (86) sont prévues dans un isolateur (6) prévu entre la cible (8) et au moins une plaque de culasse (21, 21') et/ou dans la cible (8) pour accueillir la bobine ou les bobines agencées en forme d'anneau (76, 77).

28. Dispositif selon l'une des revendications 18 à 27, dans lequel les deux bobines ou les bobines agencées en forme d'anneau (76, 77) présentent de grands diamètres différents.

29. Dispositif _selon la revendication 28, dans lequel la seconde bobine agencée en forme d'anneau (77) présente un diamètre extérieur inférieur à celui de la première bobine (76).

30. Dispositif selon l'une des revendications 19 à 29, dans lequel l'aimant en anneau (9) présente une polarité N/S pointant en direction du substrat (27).

31. Dispositif selon l'une des revendications 18 à 30, dans lequel une pièce de blindage (75) est prévue entre les deux bobines (76, 77).

32. Dispositif selon la revendication 31, dans lequel la pièce de blindage (75) est prévue entre une des plaques de culasse (21, 21') et la cible (8).

33. Dispositif selon la revendication 31, dans lequel la pièce de blindage (75) est prévue entre une des plaques de culasse (21, 21') et/ou un isolateur (6) et la cible (8).

34. Dispositif selon l'une des revendications 18 à 33, dans lequel les deux plaques de culasse (21, 21') sont agencées en direction de l'axe central (44) avec une distance l'une par rapport à l'autre.

35. Dispositif selon la revendication 34, dans lequel la distance entre les deux plaques de culasse (21, 21') correspond à peu près à la hauteur de l'aimant en anneau (9).

36. Dispositif selon la revendication 34 ou 35, dans lequel les deux plaques de culasse (21, 21') présentent de grands diamètres extérieurs différents ou bien sont agencées en échelon.

37. Dispositif selon la revendication 36, dans lequel la plaque de culasse (21) avec le plus petit diamètre extérieur, est reliée directement ou indirectement au doigt réfrigérant (74), la plaque de culasse (21') avec le plus grand diamètre extérieur est reliée directement ou indirectement à la pièce polaire (14).

38. Dispositif selon l'une des revendications 16 à 37, dans lequel le courant qui est appliqué aux bobines (76, 77) est modifiable en fonction du temps.

39. Dispositif selon l'une des revendications 16 à 38, dans lequel le courant qui est appliqué aux bobines (76, 77) ou bien l'alimentation en courant des bobines est commandable par une courbe de commande ou bien par un programme préalablement installé, les lignes d'alimentation en courant (78, 79) sont reliées à cet effet par un diviseur de courant (80) à un ordinateur (82).

40. Dispositif selon l'une des revendications 16 à 39, dans lequel la première bobine d'excitation (76) est agencée au-dessus de la plaque de culasse (21') et la seconde bobine d'excitation (77) en dessous de la plaque de culasse (21), en direction de l'axe central (44).

41. Dispositif selon l'une des revendications 16 à 40, dans lequel une seconde pièce de blindage (75') et deux secondes bobines d'excitation en forme d'anneau (76', 77') sont agencées à l'extérieur de l'espace de cible (84).

42. Dispositif selon la revendication 41, dans lequel la seconde pièce de blindage (75') et les secondes bobines d'excitation (76', 77') sont agencées de manière symétrique en miroir par rapport à la première pièce de blindage (75) et aux bobines d'excitation (76, 77) en dessous du substrat (27).

43. Procédé selon l'une des revendications 6 à 15, dans lequel on utilise
(a) un système de contrôle (95) pour surveiller les paramètres de la couche (92),
(b) un dispositif de calcul (82) pour calculer des valeurs de correction, au cas où les paramètres de couche (92) s'écarteraient de valeurs de consigne,
(c) une unité de commande (97) pour commander l'enduction en fonction des valeurs de correction.

44. Procédé selon la revendication 43, dans lequel le système de contrôle (95) dispose d'un dispositif de mesure pour mesurer les paramètres tels que la réflexion, la transmission et la densité optique de la couche (92) à des endroits prédéfinis du substrat (27).

45. Procédé selon la revendication 44, dans lequel des diodes électroluminescentes (101) sont agencées au-dessus de la couche (92) et des photodétecteurs (102) sont agencés en dessous du substrat (27) pour mesurer la transmission de la lumière émise par les diodes électroluminescentes.

46. Procédé selon l'une des revendications 43 à 45, dans lequel les paramètres de couche sont mesurés durant l'enduction, et après les paramètres d'enduction tels que la puissance de pulvérisation, le temps de pulvérisation et le champ magnétique sont réglés.

47. Procédé selon l'une des revendications 43 à 46, dans lequel les paramètres de couche sont mesurés après avoir terminé l'enduction d'un substrat, et les paramètres de procédé pendant une enduction suivante sont ajustés en fonction des résultats de mesure.

48. Procédé selon la revendication 46 ou 47 avec les étapes suivantes :
(a) Mesure des paramètres de couche,
(b) Saisie des valeurs mesurées dans le dispositif de calcul (82),
(c) Calcul de valeurs de correction pour le processus d'enduction à l'aide de valeurs de consigne prédéfinies, et
(d) Commande du processus d'enduction sur la base des valeurs de correction.

49. Procédé selon la revendication 48, dans lequel les paramètres de couche sont mesurés à l'étape (a) durant la rotation du substrat (27) autour de l'axe central, et moyennés.
